**Europäisches Patentamt**

(19) **European Patent Office**

**Office européen des brevets**

(11) Numéro de publication : **0 103 523 B1**

(12) **FASCICULE DE BREVET EUROPÉEN**

(45) Date de publication du fascicule du brevet :
27.05.87

(51) Int. Cl.⁴ : **H 01 L 21/84**, H 01 L 29/78, H 01 L 27/13

(21) Numéro de dépôt : **83401775.8**

(22) Date de dépôt : **12.09.83**

(54) Procédé de fabrication d'un écran d'affichage à base de transistors en couches minces et de condensateurs.

(30) Priorité : **14.09.82 FR 8215499**

(43) Date de publication de la demande :
**21.03.84 Bulletin 84/12**

(45) Mention de la délivrance du brevet :
**27.05.87 Bulletin 87/22**

(84) Etats contractants désignés :
**BE DE FR GB IT NL SE**

(56) Documents cités :
**EP-A- 0 051 396**
**EP-A- 0 082 783**
**GB-A- 2 077 994**
**US-A- 4 332 075**
**ELECTRONICS INTERNATIONAL, vol. 55, no. 10, 19 mai 1982, New York (US), R.T. GALLAGHER: "Amorphous silicon enlarges LCDs", pages 94-96**

(73) Titulaire : **Coissard, Pierre**
**31 Résidence Corlay**
**F-22300 Lannion (FR)**

**Richard, Joseph**
**33 Lotissement Keranroux Ploubezre**
**F-22300 Lannion (FR)**

**Morin, François**
**Le Carpont Laumerin**
**F-22300 Lannion (FR)**

(72) Inventeur : **Coissard, Pierre**
**31 Résidence Corlay**
**F-22300 Lannion (FR)**
Inventeur : **Richard, Joseph**
**33 Lotissement Keranroux Ploubezre**
**F-22300 Lannion (FR)**
Inventeur : **Morin, François**
**Le Carpont Laumerin**
**F-22300 Lannion (FR)**

(74) Mandataire : **Mongrédien, André et al**
**c/o BREVATOME 25, rue de Ponthieu**
**F-75008 Paris (FR)**

## Description

La présente invention a pour objet un procédé de fabrication d'un écran d'affichage à matrice active, à base de transistors en couches minces et de condensateurs. Elle trouve une application notamment dans la réalisation de circuits d'affichage à cristaux liquides.

Les circuits à transistors en couches minces (T.C.M.) sont principalement utilisés dans la fabrication d'écrans d'affichage à matrice active. Dans ce type d'écran, une mémoire électronique formée de points mémoire répartis sur toute la surface de l'écran, stocke le signal vidéo pendant toute la durée de l'image. Le transducteur électrooptique (par exemple un cristal liquide) est en contact avec chaque point mémoire, et est excité pendant toute la durée d'une image, alors que, dans les systèmes dépourvus de mémoire électronique, le transducteur n'est excité que pendant la durée d'une ligne. L'effet optique et le taux de multiplexage autorisé sont donc beaucoup plus importants.

Le TCM permet de réaliser une telle mémoire électronique sur un substrat de verre. Chaque point mémoire est situé au croisement d'une ligne et d'une colonne de connexion et il est constitué d'un transistor et d'un condensateur. Dans le cas où le transducteur est un cristal liquide, les armatures du condensateur peuvent être constituées par les électrodes de la cellule à cristal liquide elle-même. Le point mémoire se ramène donc à un TCM et à un condensateur dont l'une des armatures est constituée par l'électrode disposée sur la paroi de la cellule qui contient le TCM, l'autre armature étant constituée par la contre-électrode disposée sur l'autre paroi de la cellule.

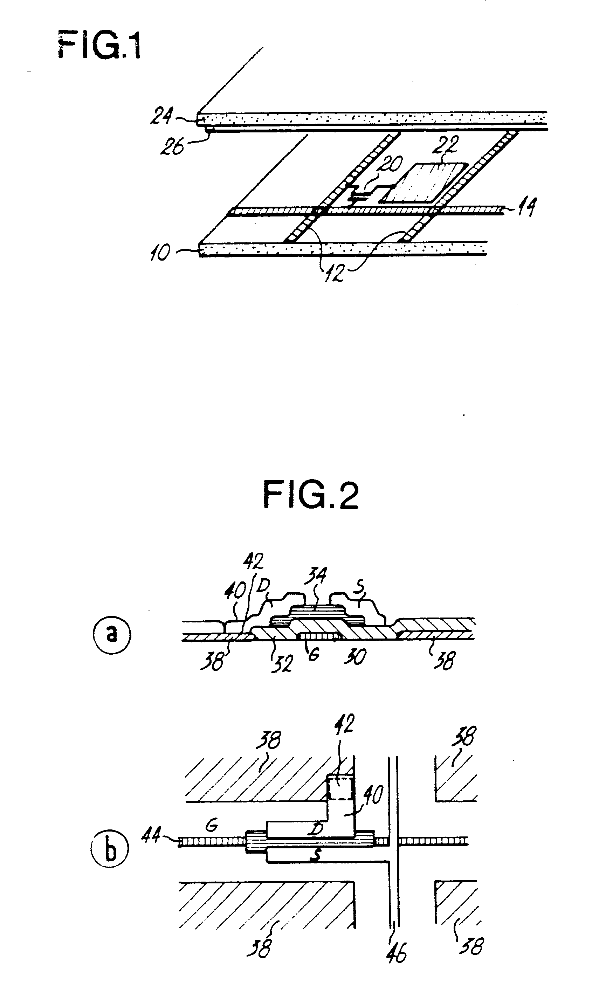

Une telle structure est représentée sur la figure 1. On y voit, d'une part, une paroi inférieure 10 portant des colonnes conductrices 12 et des lignes conductrices 14, un TCM 20 et une électrode transparente 22, et d'autre part, une paroi supérieure 24 recouverte d'une contre-électrode 26 également transparente.

A côté des matrices actives, d'autres circuits peuvent être réalisés avec des TCM et par exemple, tout ou partie de registres à décalage. De tels circuits peuvent être utilisés dans le registre vertical à cadence basse, qui permet la commutation ligne à ligne de l'écran d'affichage.

On connaît déjà des procédés de fabrication de circuits à base de TCM et de condensateurs. La figure 2 (a, b) illustre une technique décrite par A.J. SNELL et al dans un article intitulé « Application of Amorphous Silicon Field Effect Transistors in Adressable Liquid Crystal Display Panels » publié dans « Applied Physics » 24, 357-362 (1981). Le TCM est formé d'une grille G en chrome déposée sur un substrat isolant 30, d'une couche isolante 32 en nitrure de silicium ($Si_3N_4$), d'une couche de silicium amorphe 34 (a Si), d'un drain D et d'une source S en aluminium. L'armature inférieure du condensateur est formée d'une couche 38 d'oxyde d'étain et d'indium. La connexion entre le TCM et l'armature se fait par le drain D prolongé par une patte 40 qui emprunte un trou de contact 42 pratiqué dans la couche isolante 32. L'ensemble du circuit est constitué d'une pluralité de telles structures rangées sous forme matricielle. Les grilles G sont constituées par des lignes de connexion 44 et les sources par des colonnes 46.

Le procédé de réalisation d'une telle structure comprend cinq niveaux de masquage :

le premier pour la gravure de la couche conductrice 38,

le deuxième pour la gravure des grilles (G) et la gravure des lignes 44,

le troisième pour l'ouverture des fenêtres 42 dans l'isolant 32,

le quatrième pour la gravure du semiconducteur 34,

le cinquième enfin pour la gravure des contacts source-drain.

Un tel procédé présente deux inconvénients : tout d'abord il nécessite de nombreux masques ; ensuite il exige que la gravure des sources et des drains soit sélective et non polluante vis-à-vis du silicium amorphe, lequel doit être protégé par une passivation adéquate qui ne doit pas créer une zone d'accumulation à l'interface supérieur.

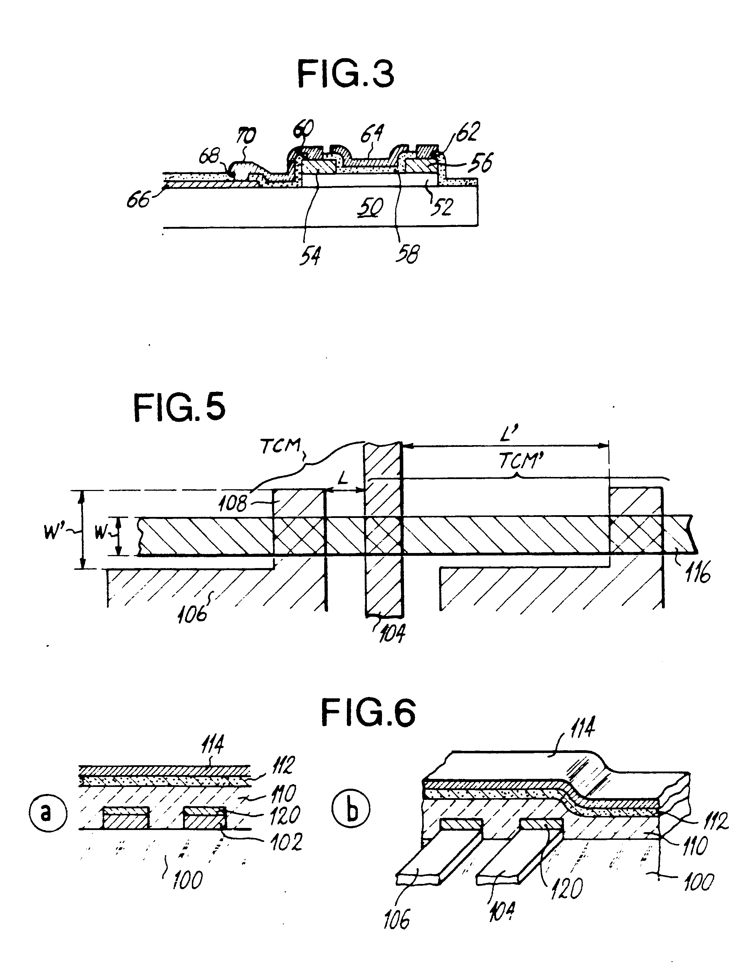

On connaît une autre technique de fabrication de TCM, dans laquelle, à la différence de la précédente, le TCM présente ses contacts de source et de drain à la partie inférieure et sa grille à la partie supérieure. Cette technique est décrite par M. Matsumura et al dans l'article intitulé « Amorphous Silicon Integrated Circuit » publié dans « Proceedings of the IEE », vol 68, n° 10, octobre 1980, pages 1349-1350. Elle est illustrée par la figure 3. Sur un support en verre 50 est déposée une couche 52 de silicium amorphe, puis une couche de silicium dopé n+, laquelle est ensuite gravée pour former les contacts de source 54 et de drain 56 ; une couche isolante 58 de silice est déposée sur l'ensemble ; des ouvertures 60, 62 sont pratiquées dans cette couche isolante pour donner accès à la source et au drain ; une couche d'aluminium forme la grille 64. L'armature du condensateur est formée par une couche 66 d'oxyde conducteur transparent, recouverte par la couche 58 de silice ; une ouverture 68 est pratiquée dans cette couche et une connexion 70 relie la source 54 à l'électrode 66.

Une telle structure nécessite six niveaux de masquage :

le premier pour la gravure de l'électrode transparente 66,

le deuxième pour la gravure de la couche 52 de aSi,

le troisième pour la gravure des contacts SiH 54 et 56,

le quatrième pour l'ouverture des fenêtres 60 et 62 dans l'isolant 58,

le cinquième pour la gravure des métallisations de drain et de source,

le sixième enfin pour la gravure des métallisations de grilles.

Une telle technique est donc encore très complexe.

La présente invention a pour but d'éviter ces inconvénients en réduisant le nombre de niveaux de masquages de 5 (ou 6) à 2. Grâce à l'invention, de meilleurs rendements de fabrication sont donc obtenus et la cadence de production des circuits est augmentée. Par ailleurs, le procédé de la présente invention ne suppose pas nécessairement que le silicium soit déposé par CVD-plasma à haute température, et d'autres techniques sont possibles, notamment celles qui opèrent à plus basse température (250 °C-300 °C).

Ces buts sont atteints, selon l'invention, par un procédé selon la revendication 1 et qui comprend, pour l'essentiel, les opérations suivantes :

dépôt sur un substrat isolant d'une couche d'un premier matériau conducteur transparent,

première photogravure appliquée à cette première couche pour constituer des pavés formant l'une des deux armatures des futurs condensateurs ainsi que des sources et des drains pour les futurs transistors,

dépôt d'une couche de silicium amorphe hydrogéné,

dépôt d'une couche isolante,

dépôt d'une couche d'un second matériau conducteur,

seconde photogravure appliquée à l'ensemble couche de silicium-couche isolante-couche conductrice, pour délimiter des grilles de commande pour les transistors.

Les caractéristiques de l'invention apparaîtront mieux après la description qui suit, d'exemples de réalisation donnés à titre explicatif et nullement limitatif. Cette description se réfère à des dessins annexés, qui font suite aux dessins représentant les figures 1 à 3 déjà décrites, et sur lesquels :

la figure 4 représente diverses étapes du procédé selon l'invention appliqué à la fabrication d'un écran d'affichage à cristaux liquides,

la figure 5 montre un détail du TCM obtenu,

la figure 6 (a, b) illustre une variante du procédé en question.

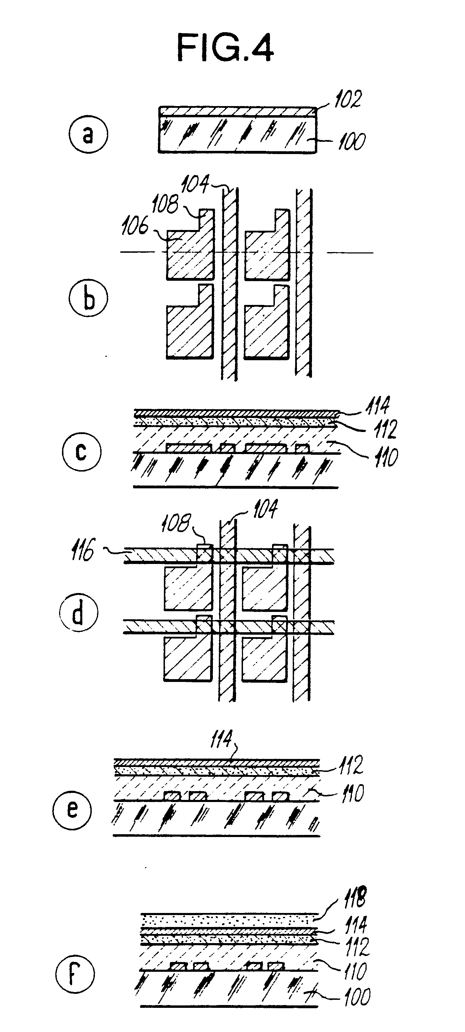

Les différentes opérations que comprend le procédé de l'invention concernant la réalisation de la paroi inférieure munie des TCM et d'une des armatures des condensateurs apparaissent en détail sur la figure 4 qui montre différents états intermédiaires du circuit obtenu. Ces opérations sont les suivantes :

Opération 1 : Préparation d'un substrat de verre 100, par exemple de la marque Corning 7059, par nettoyage physicochimique ;

Opération 2 : dépôt d'une couche 102 de matériau conducteur transparent, par exemple en oxyde d'étain et d'indium (a) ;

Opération 3 : première photogravure, pour donner à la couche 102 la forme de colonnes 104 et de pavés 106 munis d'un appendice rectangulaire 108 (b) ;

Opérations 4, 5, 6 : dépôts d'une couche de silicium amorphe hydrogéné 110, d'une couche de silice 112 et d'une couche d'aluminium 114, chaque dépôt à environ 250 °C (ou plus si on utilise la technique de CVD-plasma) (c) ;

Opération 7 : seconde photogravure, pour définir des lignes 116 chevauchant les appendices 108 et définissant les TCM (d) ; la structure vue en coupe selon une ligne est représentée sur la figure (e) ;

Opération 8 : passivation générale par dépôt d'une couche 118 de $SiO_2$ (f).

La figure 5 montre, de manière agrandie, la constitution des TCM dans la zone de chevauchement d'une ligne 116 et d'une colonne 104. La source et le drain sont respectivement constitués par l'appendice 108 et la partie de la colonne 104 située sous la ligne 116 ; la grille de commande est constituée par la partie de la ligne 116 qui est située entre l'appendice 108 et la colonne 104. On voit qu'il existe nécessairement, dans une telle structure, un transistor parasite TCM' situé de l'autre côté de la colonne 104. Mais l'écartement L' entre le drain et la source de ce transistor étant très important, la couche de aSiH se comporte en fait comme un isolant du fait de sa résistivité élevée. En revanche, pour le transistor TCM, le canal défini par l'appendice 108 et la colonne 104 est court et possède une longueur L très faible (10 μm environ), ce qui permet d'obtenir l'effet de champ requis.

On notera également que si la hauteur W' de l'appendice 108 est largement supérieure à la largeur W des lignes 116 définissant les grilles de commande, il existe une tolérance assez grande sur la position à donner à ces lignes. Ainsi, le deuxième masque peut être placé, par rapport au premier, avec une marge d'erreur qui autorise la mise en œuvre d'un alignement automatique. Cette faculté simplifie encore le procédé de l'invention.

Si l'on veut améliorer le contact entre l'oxyde 102 et la couche 110 de aSiH, on peut déposer, après l'oxyde, une couche de silicium amorphe fortement dopé n (en ajoutant par exemple du $PH_3$ dans $SiH_4$) au moment du dépôt. C'est ce qui est illustré sur la figure 6 où cette couche porte la référence 120. La gravure du premier niveau est réalisée à l'aide du même masque et cette gravure affecte alors la couche de silicium dopé 120 et celle de l'oxyde 102. Les autres opérations sont identiques. Au cours de la seconde gravure de la structure, le silicium dopé est attaqué à la suite du silicium semiconducteur. Le silicium dopé ne subsiste donc que sous la grille, au-dessus de l'oxyde (figure 6b).

## Revendications

1. Procédé de fabrication d'un écran d'affichage à matrice active formée de points constitué chacun d'un transistor en couches minces et d'un condensateur, ce procédé consistant à réaliser une paroi inférieure (10) portant des premières armatures des condensateurs et des transistors à couches minces et une paroi supérieure (24) revêtue d'une contre-électrode (26) formant seconde armature des condensateurs, ce procédé étant caractérisé en ce que, pour réaliser la paroi inférieure, on procède par les opérations suivantes :

dépôt sur un substrat isolant (100) d'une couche (102) d'un premier matériau conducteur transparent,

première photogravure appliquée à cette première couche pour constituer une matrice de pavés (106) répartis en lignes et colonnes, ces pavés formant une des armatures des futurs condensateurs, chaque pavé étant muni d'un appendice rectangulaire (108) de hauteur W', cette première photogravure laissant subsister en outre des colonnes (104) dudit premier matériau conducteur, ces colonnes étant disposées entre deux colonnes de pavés et à une distance L de ceux-ci, chaque appendice (108) étant distant de la colonne (104) la plus proche d'une longueur L et de la colonne la plus éloignée d'une longueur L', L étant beaucoup plus petit que L',

dépôt d'une couche (110) de silicium amorphe hydrogéné à résistivité élevée sur l'ensemble,

dépôt d'une couche isolante (112),

dépôt d'une couche (114) d'un second matériau conducteur,

seconde photogravure appliquée à l'ensemble couche de silicium amorphe hydrogéné-couche isolante-couche du second matériau conducteur, cette seconde photogravure laissant subsister des lignes (116) du second matériau conducteur, ces lignes ayant une largeur W inférieure à la hauteur W' des appendices (108) et passant au-dessus de ces appendices (108), les zones de recouvrement d'une ligne (116) avec une colonne (104) et l'appendice (108) le plus proche de la colonne définissant le drain et la source d'un transistor, la grille de ce transistor étant constituée par la partie de la ligne (116) qui est située entre l'appendice (108) et la colonne (104) la plus proche,

passivation générale par dépôt d'une couche (118) d'isolant.

2. Procédé selon la revendication 1, caractérisé en ce que, après la première opération de dépôt de la couche (102) du premier matériau conducteur, et avant la première photogravure, on effectue un dépôt d'une couche (120) de silicium amorphe fortement dopé n, la première photogravure affectant à la fois cette couche de silicium dopé (120) et la couche (102) du premier matériau conducteur, les autres opérations restant identiques.

**Claims**

1. Process for the manufacture of a display screen having an active matrix formed from points, each one of which is constituted by a thin-layer transistor and a condenser, this process comprising constructing a lower wall (10) carrying first electrodes of condensers and thin-layer transistors and an upper wall (24) provided with a counter-electrode (26) forming the second electrode of the condensers, this process being characterized in that, in order to construct the lower wall, the following operations are carried out :

deposit, on an insulating substrate (100), of a layer (102) of a first transparent conductive material,

first photoengraving applied to this first layer in order to form a matrix of blocks (106) distributed in lines and columns, these blocks forming one of the electrodes of the future condensers, each block being provided with a rectangular extension (108) of height W', this first photoengraving leaving moreover in existence columns (104) of the said first conductive material, these columns being disposed between two columns of blocks and at a distance L from the latter, each extension (108) being spaced from the nearest column (104) by a length L and from the furthest column by a length L', L being very much smaller than L',

deposit of a layer (110) of hydrogenated amorphous silicon having a high resistivity on the assembly,

deposit of an insulating layer (112),

deposit of a layer (114) of a second conductive material,

second photoengraving applied to the layer of hydrogenated amorphous silicon — insulating layer — layer of the second conductive material assembly, this second photoengraving leaving in existence lines (116) of the second conductive material, these lines having a width W less than the height W' of the extensions (108) and passing above these extensions (108), the zones of covering of a line (116) with a column (104) and the extension (108) closest to the column defining the drain and the source of a transistor, the gate of this transistor being formed by the part of the line (116) which is situated between the extension (108) and the closest column (104),

general passivation by deposit of a layer (118) of insulating material.

2. Process according to claim 1, characterized in that, after the first operation of deposit of the layer (102) of the first conductive material and before the first photoengraving, there is carried out a deposit of a layer (120) of strongly n-doped amorphous silicon, the first photoengraving affecting at the same time this layer of doped silicon (120) and the layer (102) of the first conductive material, the other operations remaining identical.

**Patentansprüche**

1. Verfahren zur Herstellung eines Bildschirmes mit aus Punkten gebildeter, aktiver Matrix, wobei jeder Punkt von einem Dünnschichttransistor und einem Kondensator gebildet ist und dieses Verfahren darin besteht, eine untere Wand (10), die die ersten Beläge der Kondensatoren und der Dünnschichttransistoren trägt, und eine obere Wand (24) herzustellen, die mit einer den zweiten Belag der Kondensatoren bildenden Gegenelektrode (26) überdeckt ist, dadurch gekennzeichnet, daß zum Herstellen der unteren Wand die folgenden Schritte durchgeführt werden :

Aufbringen einer Schicht (102) aus einem ersten, leitenden, transparenten Material auf einem isolierenden Substrat (100),

erstes Fotoätzen dieser ersten Schicht zur Bildung einer Matrix von Blockelementen (106), die in Zeilen und Spalten unterteilt sind, wobei diese Blockelemente einen der Beläge der zukünftigen Kondensatoren bilden und jedes Blockelement mit einem rechteckigen Ansatz (108) der Höhe W' versehen ist, wobei dieses erste Fotoätzen ferner Spalten (104) des ersten, leitenden Materials bestehen läßt, die zwischen zwei Spalten von Blockelementen und mit einem Abstand L von ihnen angeordnet sind, wobei jeder Ansatz (108) von der am nächsten liegenden Spalte (104) mit einer Länge L und von der am weitesten entfernt liegenden Spalte mit einer Länge L' beabstandet ist, wobei L viel kleiner als L' ist,

Aufbringen einer Schicht (110) aus amorphem, wasserstoffreichem Silicium mit hohem Leitungswiderstand auf der Gesamtheit,

Aufbringen einer Isolierschicht (112),

Aufbringen einer Schicht (114) aus einem zweiten, leitenden Material,

zweites Fotoätzen der Gesamtheit aus amorpher, wasserstoffreicher Schicht Isolierschicht, Schicht aus zweitem, leitendem Material, wobei dieses zweite Fotoätzen Zeilen (116) aus dem zweiten, leitenden Material bestehen läßt, die eine geringere Breite W als die Höhe W' der Ansätze (108) aufweisen und über diesen Ansätzen (108) verlaufen, wobei die Überdeckungsbereiche einer Zeile (116) mit einer Spalte (104) und dem der Spalte am nächsten liegenden Ansatz (108) die Drain und die Source eines Transistors festlegen und das Gate dieses Transistors von dem Teil der Zeile (116) gebildet wird, der sich zwischen dem Ansatz (108) und der am nächsten liegenden Spalte (104) befindet,

allgemeine Passivierung durch Aufbringen einer Isolierschicht (118).

2. Verfahren nach Anspruch 1, dadurch gekennzeichnet, daß nach dem ersten Schritt des Aufbringens der Schicht (102) aus dem ersten, leitenden Material und vor dem ersten Fotoätzen eine Schicht (120) aus amorphem, stark n-dotiertem Silicium aufgebracht wird, wobei das erste Fotoätzen gleichzeitig auf diese Schicht (120) aus dotiertem Silicium und die Schicht (102) aus dem ersten, leitenden Material einwirkt und die anderen Schritte identisch bleiben.

# FIG.1

# FIG.2

# FIG.3

# FIG.5

# FIG.6

# FIG.4